# EUROPÄISCHE PATENTSCHRIFT

(11) **EP 2 041 021 B1**
(45) Veröffentlichungstag und Bekanntmachung des Hinweises auf die Patenterteilung: **08.01.2014**
(21) Anmeldenummer: 07765351.7
(22) Anmeldetag: 11.06.2007
(51) Int. Cl.: B81B 7/00

(54) **VERFAHREN ZUR HERSTELLUNG EINES SENSORELEMENTS SOWIE SENSORELEMENT**
METHOD FOR PRODUCING A SENSOR ELEMENT AND SENSOR ELEMENT
PROCÉDÉ DE FABRICATION D'UN ÉLÉMENT CAPTEUR ET ÉLÉMENT CAPTEUR AINSI OBTENU

(30) Priorität: 10.07.2006 DE 102006031772
(43) Veröffentlichungstag der Anmeldung: 01.04.2009
(73) Patentinhaber: Robert Bosch GmbH, 70442 Stuttgart (DE)
(72) Erfinder: FEYH, Ando, 71732 Tamm (DE)
(86) Internationale Anmeldenummer: PCT/EP2007/055696
(87) Internationale Veröffentlichungsnummer: WO 2008/006651

(56) Entgegenhaltungen:
- EP-A- 1 108 677
- EP-A- 1 640 320
- EP-A- 1 640 324
- US-A1- 2003 183 916
- US-A1- 2004 245 586
- US-A1- 2005 025 215

## Beschreibung

### Stand der Technik

Die vorliegende Erfindung betrifft ein Verfahren zur Herstellung eines Sensorelements mit einer Verkappung sowie ein derartiges Sensorelement.

Sensorelemente mit Verkappungen sind beispielsweise aus der DE 10104 868 A1 bekannt. Diese Druckschrift offenbart eine Verkappung mittels eines Bondglases, wodurch eine verbesserte Ausnutzung eines Wafers zur Herstellung von Sensorelementen erreicht wird.

Aus der US 2005/0025215 A1 ist ein mikromechanischer Wärmeleitungssensor bekannt, bei dem ein Heizelement unterhalb einer porösen Kappe derart strukturiert wird, dass ein Opfermaterial, dass das Heizmaterial während der Herstellung umgibt, bei dem Herstellungsprozess entfernt wird.

Aus der US 2003/0183916 A1 ist ein mikromechanisches System mit einem hermetisch abgeschirmten Raum bekannt, bei dem in eine Kappe eingeformte Löcher anschließend mit einem Füllmaterial abgedeckt werden. In einer anderen Ausführungsform ist es auch möglich, die Kappe porös auszuführen, um mit dem Füllmaterial nach der Herstellung des mikromechanischen Systems durch Entfernen des Opfermaterials die gesamte Kappe zu verschließen.

Aus der EP 1108677 A1 ist ein Verfahren zum hermetischen Einkapseln von Mikrosystemen vor Ort bekannt, bei denen es bekannt ist, eine Kapselung im Scheitelbereich mit einer kontinuierlichen Lötmittelwelle zu verschließen.

Aus der US 2004/0245586 ist ein mikromechanisches System bekannt, bei dem zum Entfernen des Opfermaterials nach der Herstellung der Kammer eine Öffnung in die Abschirmung eingebracht wird.

Ferner ist es bekannt, zur Verkappung sogenannte Kappenwafer zu verwenden. Dieses Verfahren hat jedoch den Nachteil, dass zwei Wafer zur Herstellung des Sensorelements notwendig sind, wodurch die Herstellkosten entsprechend verteuert werden.

### Vorteile der Erfindung

Das erfindungsgemäße Verfahren zur Herstellung eines Sensorelements mit einer Verkappung weist demgegenüber den Vorteil auf, dass es besonders kostengünstig durchführbar ist. Dadurch kann erfindungsgemäß eine signifikante Reduzierung der Herstellungskosten für Sensorelemente mit Verkappung erreicht werden. Erfindungsgemäß umfasst das Verfahren dabei die Schritte des Bereitstellens eines Substrats mit einer Sensorstruktur, wobei die Sensorstruktur mittels eines Opfermaterials in dem Substrat erzeugt wird. Anschließend wird eine Verkappung aus Zeolith auf die Sensorstruktur und das noch im Substrat befindliche Opfermaterial aufgebracht. Als nächster Schritt wird das Opfermaterial entfernt, wobei die Entfernung des Opfermaterials durch das Zeolith hindurch erfolgt. Um Verschmutzungen der Sensorstruktur bzw. ein Zerstören der Sensorstruktur durch aufgebrachtes Zeolith als Verkappung zu vermeiden, wird das Opfermaterial erst nach Herstellung der Verkappung aus Zeolith entfernt.

Die Unteransprüche zeigen bevorzugte Weiterbildungen der Erfindung.

Als Zeolith wird vorzugsweise ein Zeolith aus der Gruppe der Alumosilikate verwendet.

Vorzugsweise wird das Zeolith für die Verkappung mittels einer Suspension aufgebracht. In einem anschließenden Schritt erfolgt eine Trocknung der Suspension, so dass das Zeolith auf dem Substrat verbleibt.

Gemäß einer bevorzugten Ausgestaltung der Erfindung wird das Opfermaterial mittels eines Ätzgases in einem Gasphasenprozess entfernt. Dieser Prozess kann besonders einfach und kostengünstig durchgeführt werden. Als Ätzgas wird dabei besonders bevorzugt CLF₃-Gas- und/oder HF-Dampf verwendet.

Um ein möglichst einfaches Entfernen des Opfermaterials zu ermöglichen, umfasst das Opfermaterial vorzugsweise Si oder SiGe oder SiO₂.

Besonders bevorzugt wird das Zeolith derart aufgebracht, dass das Zeolith eine definierte Porengröße aufweist. Dadurch können gewünschte Eigenschaften des herzustellenden Sensorelements in Abhängigkeit vom Einsatzzweck des Sensorelements erreicht werden. Die Porengröße des Zeoliths ist dabei vorzugsweise zwischen ca. 1 nm bis ca. 1 µm. Besonders bevorzugt ist die Porengröße kleiner als 100 nm.

Erfindungsgemäß wird auf das Zeolith eine Schutzschicht aufgebracht. Hierdurch kann ein Schutz des Zeoliths sowie seiner darunter befindlichen Sensorstruktur erreicht werden. Die Schutzschicht kann dabei gasdicht sein, so dass das Zeolith vollständig versiegelt ist. Hierbei ist dann besonders bevorzugt, dass die Porengröße des Zeoliths sehr klein ist. Ferner kann hierbei eine gewünschte Atmosphäre im Bereich der Sensorstruktur eingeschlossen werden. Alternativ kann die Schutzschicht auch definiert gasdurchlässig sein, wenn die Sensorstruktur beispielsweise zur Erfassung von bestimmten Gasen ausgelegt ist.

Die Schutzschicht wird auf das Zeolith vorzugsweise mittels eines Sputterverfahrens oder mittels eines CVD-Verfahrens, insbesondere eines PECVD-Verfahrens (Plasma Enhanced Chemical Vapour Deposition). Eine Schichtdicke ist dabei vorzugsweise zwischen 10 nm und 100 nm.

Es sei angemerkt, dass durch das erfindungsgemäße Verfahren insbesondere mikromechanische Sensorelemente verkappt werden können.

Ferner betrifft die vorliegende Erfindung ein Sensorelement, welches ein Substrat, eine Sensorstruktur und eine Verkappung umfasst, wobei die Verkappung aus Zeolith hergestellt ist und über der Sensorstruktur angeordnet ist. Die Verkappung deckt somit die Sensorstruktur ab und schützt diese.

Die Verkappung weist dabei besonders bevorzugt eine gleichmäßige Dicke über der Sensorstruktur auf.

Die Sensorstruktur des erfindungsgemäßen Sensorelements umfasst vorzugsweise eine Vielzahl von Fingerelementen, welche mit einem Ende am Substrat fixiert sind und deren anderes Ende freiliegt. Hierdurch können beispielsweise Bewegungen der Fingerelemente durch die Sensorstruktur erfasst werden.

Weiter bevorzugt umfasst das Sensorelement eine Beschichtung, welche über der Verkappung aus Zeolith angeordnet ist. Die Beschichtung kann beispielsweise gasdicht ausgebildet sein. Ferner kann die Beschichtung eine Schutzfunktion für das Zeolith und/oder die Sensorstruktur aufweisen. Alternativ kann die Beschichtung auch definiert gasdurchlässig sein, wobei die Beschichtung Poren mit vorbestimmten maximalen Öffnungsquerschnitten aufweist. Die Dicke der Beschichtung ist vorzugsweise zwischen 10 nm und 100 nm. Eine durchlässige Beschichtung wird insbesondere für Gassensoren verwendet.

Eine gasdichte Beschichtung wird beispielsweise für Inertialsensoren zur Verwendung in Fahrzeugen verwendet.

### Zeichnung

Nachfolgend werden bevorzugte Ausführungsbeispiele der Erfindung unter Bezugnahme auf die begleitende Zeichnung beschrieben. In der Zeichnung ist:
- Figur 1: eine schematische Schnittansicht, die die Herstellung einer Sensorstruktur mittels eines Opfermaterials zeigt,
- Figur 2: eine schematische Schnittansicht, welche das Sensorelement nach dem Aufbringen der Verkappung zeigt,
- Figur 3: eine schematische Schnittansicht, welche das Sensorelement nach Entfernen des Opfermaterials zeigt, und
- Figur 4: eine schematische Schnittansicht, welche einen weiteren Verfahrensschritt des Aufbringens einer Beschichtung darstellt.

### Beschreibung von bevorzugten Ausführungsformen der Erfindung

Nachfolgend werden unter Bezugnahme auf die begleitenden Figuren Ausführungsbeispiele der Erfindung im Detail näher erläutert.

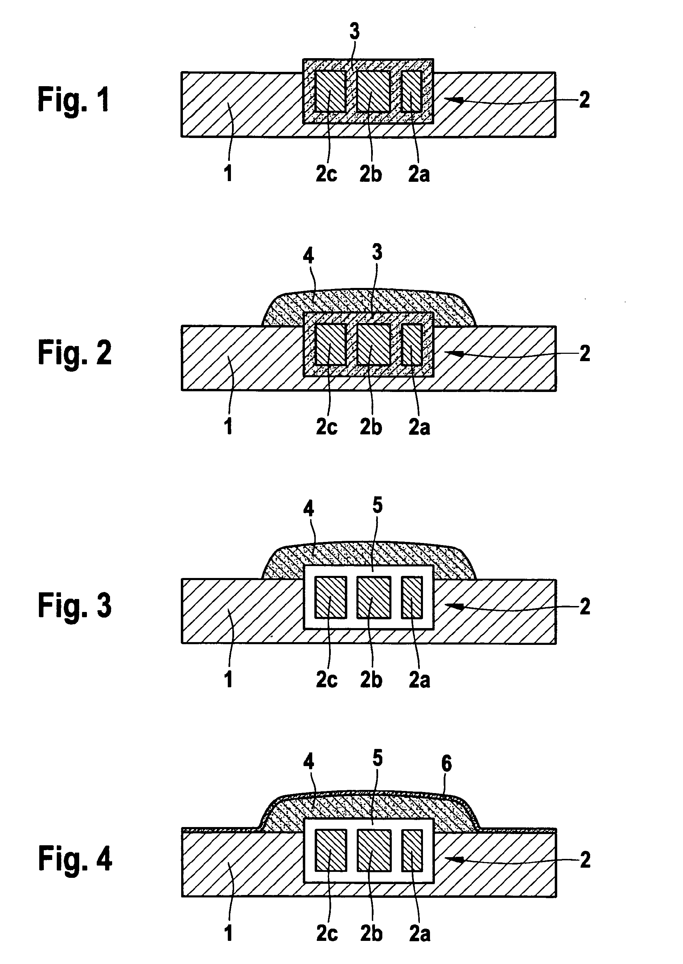

Das erfindungsgemäße Verfahren umfasst in einem ersten Schritt das Bereitstellen eines Substrats 1 mit einer Sensorstruktur 2. Wie in Figur 1 gezeigt, wird die Sensorstruktur 2 in das Substrat 1 mittels eines Opfermaterials 3 eingebracht. Die Sensorstruktur 2 dieses Ausführungsbeispiels umfasst drei Sensorelemente 2a, 2b, 2c, deren eines Ende am Substrat 1 fixiert ist und deren anderes Ende frei ist. Als Opfermaterial wird beispielsweise SiGe verwendet, welches mittels eines Gasphasenprozesses entfernt werden kann.

Nach dem Herstellen der Sensorstruktur 2 wird, wie in Figur 2 gezeigt, in einem nächsten Schritt eine Kappe bzw. Verkappung 4 über die Sensorstruktur 2 und das Opfermaterial 3 aufgebracht. Die Verkappung 4 kann beispielsweise mittels einer Suspension aufgebracht werden und anschließend getrocknet werden. Die Verkappung 4 umschließt die Sensorstruktur 2 derart, dass sie von der Umgebung separiert ist. Die Verkappung 4 ist aus einem Zeolith, wobei die Porengröße des Zeoliths definiert einstellbar ist. Der Zeolith besteht vorzugsweise aus Aluminium und Silizium. Somit ist er kompatibel zu den gängigen Halbleiterprozessen.

Nachdem die Verkappung aus Zeolith aufgebracht ist und getrocknet ist, wird in einem nächsten Schritt das Opfermaterial 3 entfernt. Dies wird mittels Gasphasenätzen durchgeführt. Je nach verwendetem Opfermaterial wird hierbei ein spezielles Ätzgas, z.B. CIF₃ oder HF-Dampf, verwendet. Nachdem das Opfermaterial 3 entfernt wurde, sind die drei Fingerelemente 2a, 2b, 2c freiliegend im Substrat 1 angeordnet. Ein Hohlraum zwischen den Fingerelementen 2a, 2b, 2c der Sensorstruktur 2 ist in Figur 3 mit dem Bezugszeichen 5 bezeichnet.

Die Verwendung des Zeoliths hat ferner den Vorteil, dass sie halbleiterkompatibel ist und daher die entsprechenden Prozesse und Anlagen genutzt werden können, welche schon zur Herstellung der Sensorstruktur verwendet werden. Von daher kann die Herstellung des erfindungsgemäßen Sensorelements sehr einfach sein. Die Struktur des Zeoliths kann betreffend die Morphologie sehr definiert eingestellt werden, wobei neben der Porengröße auch eine Porenstruktur bzw. ein Verzweigungsgrad der Porenstruktur eingestellt werden kann.

Da der Zeolith die Porenstruktur aufweist, kann eine Entfernung des Opfermaterials 3 durch den Zeolith hindurch erfolgen. Hierbei wird insbesondere auf ein nasschemisches Ätzen verzichtet, da beim Trocknen das sogenannte Sticking auftreten kann, bei welchem die Fingerelemente am Substrat ankleben können.

Ein wie in Figur 3 gezeigtes Sensorelement kann beispielsweise als Gassensor verwendet werden. Das Zeolith ist hierbei gasdurchlässig, so dass das entsprechende Gas an die Sensorstruktur 2 gelangen kann.

In Figur 4 ist alternativ noch ein weiterer Verfahrensschritt dargestellt, welcher das Aufbringen einer zusätzlichen Beschichtung 6 zeigt. Die Beschichtung 6 hat eine Schutzfunktion für das Zeolith 4 und kann noch weitere Funktionen übernehmen. Beispielsweise kann die Beschichtung 6 gasdicht ausgeführt sein, so dass die Sensorstruktur 2 gasdicht im Substrat 1 angeordnet ist. Ferner kann hierbei ein gewünschtes Gas im Hohlraum 5 im Bereich der Sensorstruktur 2 eingeschlossen werden. Es sei angemerkt, dass bei Aufbringen einer Beschichtung 6 vorzugsweise die Porengröße des Zeoliths derart gewählt ist, dass sie möglichst klein ist, z.B. zwischen ca. 10 nm bis 100 nm, so dass ein einfaches Verschließen der Zeolithstruktur möglich ist. Als Schichtabscheideverfahren können beispielsweise Sputterverfahren oder PECVD-Verfahren verwendet werden. Ein derartiger Sensor kann beispielsweise als Inertialsensor verwendet werden.

Gemäß der vorliegenden Erfindung wird somit eine besonders kostengünstige Verkappung von Sensorelementen mittels eines Zeolith 4 beschrieben. Insbesondere können hierbei die im Halbleiterprozess vorhandenen Geräte und Verfahren verwendet werden, wodurch die Herstellung von verkappten Sensorelementen signifikant verbilligt werden kann.

## Patentansprüche

1. Verfahren zur Herstellung eines verkappten Sensorelements, umfassend die Schritte:
- Bereitstellen eines Substrats (1) mit einer Sensorstruktur (2), wobei die Sensorstruktur (2) mittels eines Opfermaterials (3) in dem Substrat (1) erzeugt wird,
- Anbringen einer Kappe (4) auf die Sensorstruktur (2) und das Opfermaterial (3),
- Entfernen des Opfermaterials (3), wobei das Opfermaterial (3) durch die Kappe (4) aus Zeolith hindurch entfernt wird,
- Aufbringen einer gasdichte Schutzschicht (6) auf die Kappe (4), **dadurch gekennzeichnet dass** die Kappe aus Zeolith besteht.

2. Verfahren nach Anspruch 1, **dadurch gekennzeichnet, dass** das Zeolith mittels einer Suspension aufgebracht wird und anschließend ein Trocknungsschritt erfolgt, um das Zeolith abzuscheiden.

3. Verfahren nach einem der vorhergehenden Ansprüche, **dadurch gekennzeichnet, dass** das Opfermaterial (3) mittels eines Ätzgases in einem Gasphasenprozess entfernt wird.

4. Verfahren nach Anspruch 3, **dadurch gekennzeichnet, dass** als Ätzgas ein CIF₃-Gas oder HF-Dampf verwendet wird.

5. Verfahren nach einem der vorhergehenden Ansprüche, **dadurch gekennzeichnet, dass** das Opfermaterial Silizium umfasst oder aus SiGe hergestellt ist oder aus SiO₂ hergestellt ist.

6. Verfahren nach einem der vorhergehenden Ansprüche, **dadurch gekennzeichnet, dass** das Zeolith der Kappe (4) eine definierte Porengröße aufweist.

7. Verfahren nach Anspruch 6, **dadurch gekennzeichnet, dass** die Porengröße des Zeoliths der Kappe (4) zwischen ca. 1 nm bis ca. 1 µm liegt und insbesondere kleiner als 100 nm ist.

8. Verfahren nach einem der vorhergehenden Ansprüche, **dadurch gekennzeichnet, dass** die Schutzschicht (6) eine Dicke zwischen 10nm und 100nm aufweist.

9. Verfahren nach einem der vorhergehenden Ansprüche, **dadurch gekennzeichnet, dass** die Schutzschicht (6) mittels eines Sputterverfahrens oder mittels eines PECVD-Verfahrens aufgebracht wird.

10. Verfahren nach einem der vorhergehenden Ansprüche, **dadurch gekennzeichnet, dass** als Zeolith ein Zeolith aus der Gruppe der Alumosilikate verwendet wird.

11. Sensorelement, hergestellt nach einem Verfahren nach einem der vorhergehenden Ansprüche umfassend ein Substrat (1), eine Sensorstruktur (2), eine Kappe (4) und eine auf der Kappe angeordnete gasdichte Schutzschicht (6), wobei die Kappe (4) über der Sensorstruktur (2) angeordnet ist, **dadurch gekennzeichnet dass** die Kappe aus Zeolith besteht.

12. Sensorelement nach Anspruch 11, **dadurch gekennzeichnet, dass** die Sensorstruktur (2) eine Vielzahl von Fingerelementen (2a, 2b, 2c) umfasst.

13. Sensorelement nach Anspruch 11 oder 13, **dadurch gekennzeichnet, dass** die Schutzschicht (6) als eine Beschichtung mit einer Dicke zwischen 10nm und 100nm ausgeführt ist.

## Claims

1. Method for producing a capped sensor element, comprising the following steps:
- providing a substrate (1) with a sensor structure (2), the sensor structure (2) being produced in the substrate (1) by means of a sacrificial material (3),
- fitting a cap (4) to the sensor structure (2) and the sacrificial material (3),
- removing the sacrificial material (3), the sacrificial material (3) being removed through the cap (4) made of zeolite,
- applying a gas-tight protective layer (6) to the cap (4),
**characterized in that** the cap consists of zeolite.

2. Method according to Claim 1, **characterized in that** the zeolite is applied by means of a suspension, and then a drying step is carried out in order to deposit the zeolite.

3. Method according to either of the preceding claims, **characterized in that** the sacrificial material (3) is removed in a gas phase process by means of an etching gas.

4. Method according to Claim 3, **characterized in that** the etching gas used is a CIF₃ gas or HF vapour.

5. Method according to one of the preceding claims, **characterized in that** the sacrificial material comprises silicon or is produced from SiGe or is produced from SiO₂.

6. Method according to one of the preceding claims, **characterized in that** the zeolite in the cap (4) has a defined pore size.

7. Method according to Claim 6, **characterized in that** the pore size of the zeolite in the cap (4) is between approximately 1 nm and approximately 1 µm, and in particular is smaller than 100 nm.

8. Method according to one of the preceding claims, **characterized in that** the protective layer (6) has a thickness of between 10 nm and 100 nm.

9. Method according to one of the preceding claims, **characterized in that** the protective layer (6) is applied by means of a sputtering process or by means of a PECVD process.

10. Method according to one of the preceding claims, **characterized in that** the zeolite used is a zeolite selected from the group consisting of the aluminosilicates.

11. Sensor element, produced by a method according to one of the preceding claims, comprising a substrate (1), a sensor structure (2), a cap (4) and a gas-tight protective layer (6) arranged on the cap, the cap (4) being arranged over the sensor structure (2), **characterized in that** the cap consists of zeolite.

12. Sensor element according to Claim 11, **characterized in that** the sensor structure (2) comprises a multiplicity of finger elements (2a, 2b, 2c).

13. Sensor element according to Claim 11 or 12, **characterized in that** the protective layer (6) is in the form of a coating having a thickness of between 10 nm and 100 nm.

## Revendications

1. Procédé de fabrication d'un élément de capteur encapuchonné, comportant les étapes qui consistent à :
préparer un substrat (1) doté d'une structure de capteur (2), la structure de capteur (2) étant formée dans le substrat (1) au moyen d'un matériau sacrifié (3),
placer un capuchon (4) sur la structure de capteur (2) et le matériau sacrifié (3),
enlever le matériau sacrifié (3), le matériau sacrifié (3) étant enlevé à travers le capuchon (4) en zéolithe,
appliquer une couche de protection (6) étanche au gaz sur le capuchon (4),
**caractérisé en ce que**
le capuchon est constitué de zéolithe.

2. Procédé selon la revendication 1, **caractérisé en ce que** la zéolithe est appliquée au moyen d'une suspension et subit ensuite une étape de séchage qui précipite la zéolithe.

3. Procédé selon l'une des revendications précédentes, **caractérisé en ce que** le matériau sacrifié (3) est enlevé au moyen d'un gaz de gravure dans une opération en phase gazeuse.

4. Procédé selon la revendication 3, **caractérisé en ce qu'**il utilise comme gaz de gravure un gaz à base de ClF₃ ou une vapeur de HF.

5. Procédé selon l'une des revendications précédentes, **caractérisé en ce que** le matériau sacrifié comporte du silicium ou est réalisé à partir de SiGe, ou est réalisé en SiO₂.

6. Procédé selon l'une des revendications précédentes, **caractérisé en ce que** la zéolithe du capuchon (4) présente des pores d'une taille définie.

7. Procédé selon la revendication 6, **caractérisé en ce que** la taille des pores de la zéolithe du capuchon (4) est située entre environ 1 nm et environ 1 µm et est en particulier inférieure à 100 nm.

8. Procédé selon l'une des revendications précédentes, **caractérisé en ce que** la couche de protection (6) présente une épaisseur comprise entre 10 nm et 100 nm.

9. Procédé selon l'une des revendications précédentes, **caractérisé en ce que** la couche de protection (6) est appliquée au moyen d'une opération de pulvérisation ou au moyen d'un procédé PECVD.

10. Procédé selon l'une des revendications précédentes, **caractérisé en ce qu'**il utilise comme zéolithe une zéolithe sélectionnée dans l'ensemble des aluminosilicates.

11. Elément de capteur fabriqué en appliquant un procédé selon l'une des revendications précédentes et comportant
un substrat (1), une structure de capteur (2), un capuchon (4) et une couche de protection (6) étanche au gaz disposée sur le capuchon,
le capuchon (4) étant disposé au-dessus de la structure de capteur (2),
**caractérisé en ce que**
le capuchon est constitué de zéolithe.

12. Elément de capteur selon la revendication 11, **caractérisé en ce que** la structure de capteur (2) comporte plusieurs éléments en doigts (2a, 2b, 2c).

13. Elément de capteur selon les revendications 11 ou 12, **caractérisé en ce que** la couche de protection (6) est réalisée sous la forme d'un revêtement d'une épaisseur comprise entre 10 nm et 100 nm.
